# EUROPEAN PATENT SPECIFICATION

(11) **EP 0 295 708 B1**
(45) Date of publication and mention of the grant of the patent: **23.02.1994**
(21) Application number: 88109700.0
(22) Date of filing: 16.06.1988
(51) Int. Cl.: H01L 23/52, H01L 21/90, H01L 39/24

(54) **Semiconductor device having a superconductive wiring**
Halbleiteranordnung mit einer supraleitenden Metallisierung
Dispositif semi-conducteur comprenant une métallisation supraconductrice

(30) Priority: 18.06.1987 JP 150248/87
(43) Date of publication of application: 21.12.1988
(73) Proprietor: FUJITSU LIMITED, Kawasaki-shi, Kanagawa 211 (JP)
(72) Inventor: Taguchi, Masao, Sagamihara-shi Kanagawa, 228 (JP)
(74) Representative: Schmidt-Evers, Jürgen, Dipl.-Ing.

(56) References cited:
- EP-A- 0 299 163
- EP-A- 0 303 521
- EP-A- 0 336 505
- PATENT ABSTRACTS OF JAPAN, vol. 11, no. 33 (E-476)[2480], 30th January 1987; & JP-A-61 201 467
- PATENT ABSTRACTS OF JAPAN, vol. 9, no. 321 (E-367)[2044], 17th December 1985; & JP-A-60 154 613
- J.E.E. JOURNAL OF ELECTRONIC ENGINEERING, vol. 21, no. 216, December 1984, pages 32-36, Tokyo, JP; H. SAKAKI et al.: "An introduction to new possibilities in high-speed heterojunction FETs"
- PATENT ABSTRACTS OF JAPAN, vol. 10, no. 370 (E-463)[2427], 10th December 1986; & JP-A-61 164 271

## Description

This invention relates to a semiconductor device whose wiring layer is formed of a superconductive material.

Materials employed as electrodes or wirings of semiconductor devices, such as IC (integrated circuits), have been generally a metal, such as aluminum, or a semiconductor material, such as polycrystalline silicon. Today, as well recognized, it is the most essential target for the ICs to improve the operating speed as well as the integration density. To enhance the integration density, the wiring must be as narrow as possible. However, even if an electrically good conductive metal is used for the wiring layer, such a narrow wiring as sub micron meter causes an increase of the electrical resistance, which consequently causes a delay as well as decay of the signal propagation on the IC.

On the other hand, in the recent few years, research and development of an electrically superconductive (hereinafter referred to as superconductive) material which has a zero electrical resistance below a certain temperature, such as 77 K (Kelvin), the boiling temperature of the liquid nitrogen, has been successfully achieved in a form of ceramic. The superconductive ceramic materials of this relatively high temperature range have been reported as a compound composed of yttrium (Y), barium (Ba), copper (Cu), and oxygen, as well as a compound composed of barium, lanthanum (La), copper, and oxygen. These compounds are firstly formed in a thin film layer, and then heat-treated in an oxygen-containing atmosphere so that the material be superconductive. Application of this superconductive ceramic material to the above-mentioned IC layer wiring can make the wiring's electrical resistance zero, with which the signals or the power source voltage can be delivered to the destination without delay or decay. Thus, the superconductive material is particularly advantageously applicable to a HEMT (high electron mobility transistor), which is particularly promising in achieving remarkably high speed operation requiring a low temperature below 77 K.

However, in the application of the superconductive ceramic material to the semiconductor wiring layer simply in place of a metal layer wiring formed of a normal conductive state metal (i.e. not superconductive metal), which is hereinafter referred to as a normal metal, such as aluminum or gold, there are problems in that:
(1) At a contact where the superconductive ceramic material directly contacts the semiconductor material, atoms in the superconductive material react with atoms in the semiconductor material. Particularly, the copper being abundantly contained in the superconductive material easily forms an eutectic alloy with silicon (Si) in the semiconductor silicon substrate, and penetrates further into the silicon substrate.
   (1-1) When the copper atom reaches a p-n junction, it causes the breakdown voltage of the p-n junction to lower, the reverse current of the p-n junction to increase, the current gain of a bipolar transistor to decrease as the results of the shorten life time of carriers in the bipolar transistor formed therein, or becomes a generation and recombination centre of the carriers thus results in noise generation.
   (1-2) When the copper atom reaches a MOS (metal oxide semiconductor) structure, it lowers the dielectric breakdown voltage.
   (1-3) Ohmic contact is not always accomplished between the superconductive wiring layer and the semiconductor region, thus there appears a rectifier characteristic or a high electrical resistance.
(2) The superconductive ceramic materials reported in public are mostly of bulk, i.e. of a random layer structure or electrically isotropic characteristics; however, when the superconductive material is formed in a thin film for fabricating the wiring layer of an LSI (large scale IC) by means of widely used epitaxial growth technique, such as a molecular beam epitaxy (MBE) or a reactive sputtering method, the atoms or molecules are deposited in a particular orientation, i.e. the layered structure becomes anisotropic. This particular orientation of the atoms/molecules is that the superconductive material form a layered structure extending in parallel to the substrate's surface plane, for example, (1 1 0) on which the wiring layer is deposited also in the plane (1 1 0) (FIG. 8(a)). Then, the layer can be superconductive mainly in the direction of the above-mentioned substrate's surface plane direction (1 1 0), which is referred to hereinafter as horizontal direction). In other words, the electrical resistance in an orthogonal direction to the horizontal direction, i.e. across the thickness of the layers as indicated by an arrow mark B in FIG. 8(a), does not become zero. In the strict sense of the word, the critical value of the superconductive current in the thickness direction is much less than that of the horizontal direction.

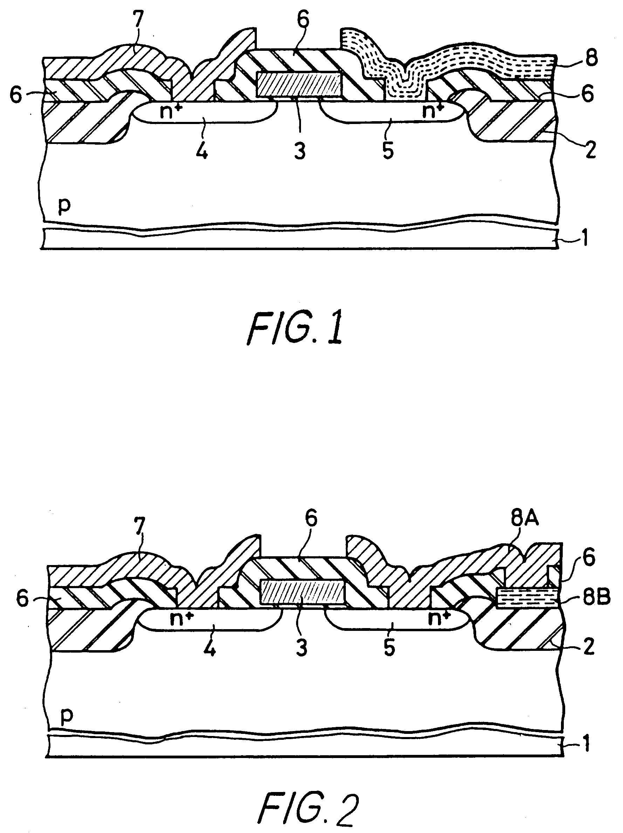

Referring to practical samples, the above-described problems are hereinafter explained. FIG. 1 shows a cross-sectional view of a sample made of a general MOS transistor in which an electrode and wiring of the drain are formed of the superconductive ceramic material. The numeral 1 denotes a p-type silicon substrate; the numeral 2 denotes a field isolation layer formed of silicon dioxide (SiO₂); the numeral 3 denotes a gate electrode formed of a polycrystalline silicon; the numeral 4 denotes an n⁺-type source region, the numeral 5 denotes an n⁺-type drain region; the numeral 6 denotes an inter-layer insulation film formed of SiO₂; the numeral 7 denotes a source electrode formed of aluminum; and the numeral 8 denotes an electrode/wiring formed of the superconductive ceramic material of the drain electrode 5. In this sample, the direct contact of the drain electrode/wiring 8 made of the superconductive ceramic material with the n⁺-type drain region 5 not only produces a high electrical contact resistance deteriorating the beneficial advantage of employing the superconductive material, but also produces their alloy to cause a junction leakage.

FIG. 2 shows a cross-sectional view of another sample made of a MOS transistor in which a drain electrode is formed of aluminum, a normal metal, connecting the drain region to a drain wiring formed of the superconductive ceramic material. In FIG. 2, the same numerals denote the same parts or the parts having the same function as those in FIG. 1. The numeral 8A denotes a drain electrode, and the numeral 8B denotes a drain wiring. In this sample, the reaction of the superconductive ceramic material with the n⁺-type drain region is prevented because the superconductive material 8B does not directly contact the n⁺-type silicon drain region 5.

Furthermore, if the drain wiring 8B is anisotropic, the contact resistance particularly increases, because the aluminium electrode 8A contacts the superconductive wiring layer 8B at its horizontal surface, through which the superconductive property is not realized. Accordingly, the beneficial advantage of employing the superconductive ceramic material cannot be enjoyed at all.

It is general object of the invention therefore to provide a semiconductor device structure which prevents the superconductive layer wiring from forming an undesirable alloy with the semiconductor region or mutual diffusion of the atoms of both compositions, so that the deterioration of the semiconductor region as well as the superconductive material is prevented.

It is another object of the invention to provide a semiconductor device structure in which the contact resistance between the superconductive layer wiring and the semiconductor region is ohmic and adequately low even when the superconductive layer is anisotropically superconductive mainly in a direction parallel to a plane of the layer deposition.

It is still another object of the invention to provide a MESFET (Metal Semiconductor FET, for example, a HEMT structure in which a gold-germanium alloy electrode designed not to cause an excessive alloy with the GaAs or the AlGaAs layers during a high temperature heat processing for forming a superconductive wirings, accordingly the performance as well as the reliability in operation is satisfactorily achieved.

An electrode formed of a normal metal, which is electrically non-superconductive, such as aluminum or gold-germanium alloy, provided on a semiconductor region, contacts a layer wiring anisotropically superconductive mainly in direction parallel to the plane of the layer's deposition on an insulation layer contacts, at least at the anisotropically superconductive layer wiring's side wall, which is essentially orthogonal to the plane of the layer wiring. The contact resistance between the superconductive layer and the electrode is ohmic and essentially zero, while preventing a reaction of the copper atoms in the superconductive material with the silicon atoms in the semiconductor region to form an alloy, accordingly preventing the deterioration of the semiconductor region as well as the superconductive material.

The above-mentioned features and advantages of the present invention, together with other objects and advantages, which will become apparent, will be more fully described hereinafter, with reference being made to the accompanying drawings which form a part hereof, wherein like numerals refer to like parts throughout.

FIG. 1 schematically illustrates a cross-sectional view of a semiconductor device having a superconductive layer wiring thereon.

FIG. 2 schematically illustrates a cross-sectional view of another semiconductor device having a superconductive layer wiring thereon.

FIG. 3 schematically illustrates the principle of the present invention.

FIG. 4 schematically illustrates a cross-sectional side view of an embodiment of the present invention concerning a bipolar transistor.

FIG. 5 schematically illustrates a plan view of the electrodes and the layer wirings of the embodiment of FIG. 4.

FIG. 6a schematically illustrates a cross-sectional view of an intermediate step of fabrication of another embodiment of the present invention concerning a MOS FET of FIG. 6b.

FIG. 6b schematically illustrates a cross-sectional view of the another embodiment concerning a MOS FET according to the present invention.

FIG. 7a schematically illustrates a cross-sectional side view of an intermediate step of fabrication of a further embodiment of the present invention concerning a MESFET, and in particular, of a HEMT of FIG. 7d.

FIG. 7b schematically illustrates a cross-sectional side view of another intermediate step of fabrication of the HEMT of FIG. 7d.

FIG. 7c schematically illustrates a cross-sectional side view of still another intermediate step of fabrication of the HEMT of FIG. 7d.

FIG. 7d schematically illustrates a cross-sectional side view of the HEMT.

FIGs. 8 schematically illustrate variation of contact points with side-walls of the superconductive layer wiring.

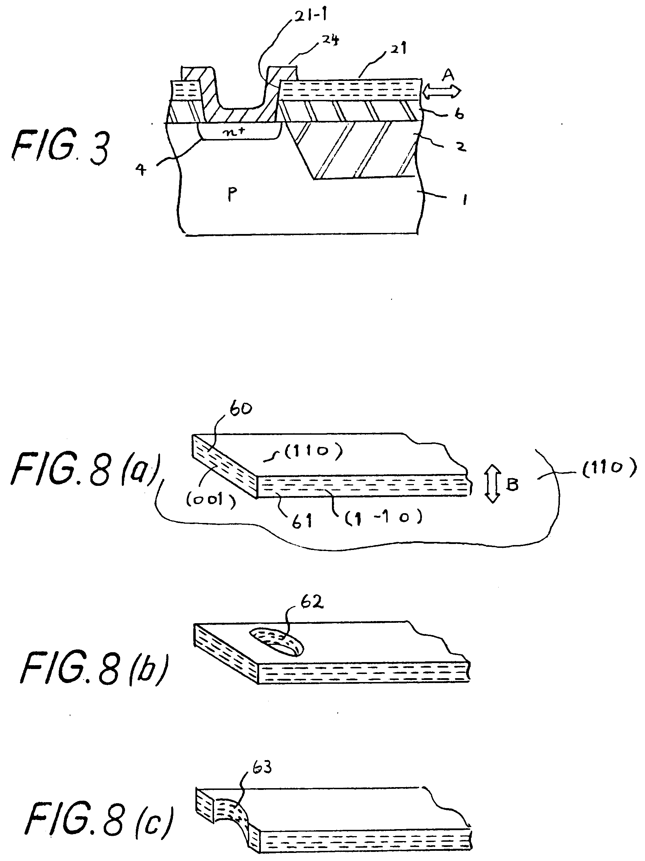

Referring to FIG. 3, the principle of the present invention is schematically illustrated. An inter-layer insulation film 6 is formed upon a semiconductor substrate 1, having a semiconductor region 4 and a field isolation 2 except on the semiconductor region 4. A wiring layer 21 formed of a superconductive material is formed upon the insulation film 6. An electrode 23 of a normal metal, such as aluminum, is formed on the semiconductor region 4 to electrically connect the semiconductor region to the superconductive layer wiring 21 at least through a plane 21-1 which is essentially orthogonal to the plane of the of the layer wiring 21. Mainly in the direction through the this plane, i.e. the direction indicated by the arrow mark A, the layer wiring is orthogonally superconductive.

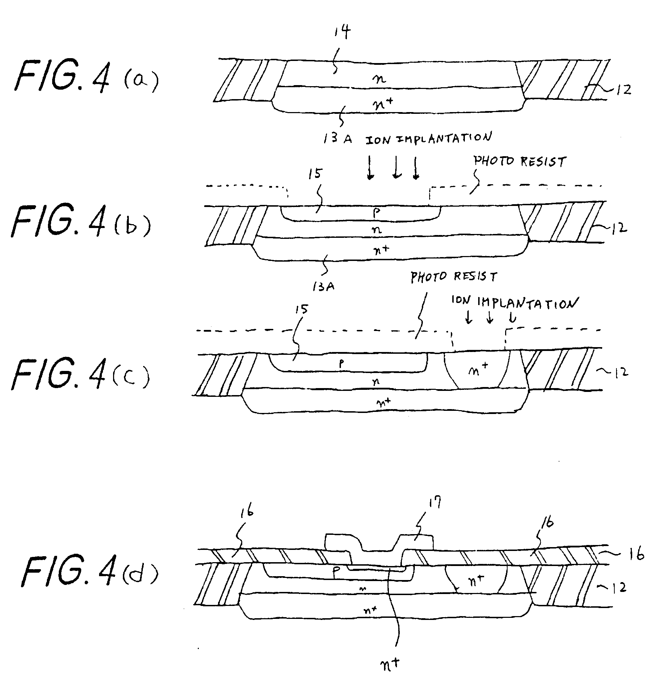

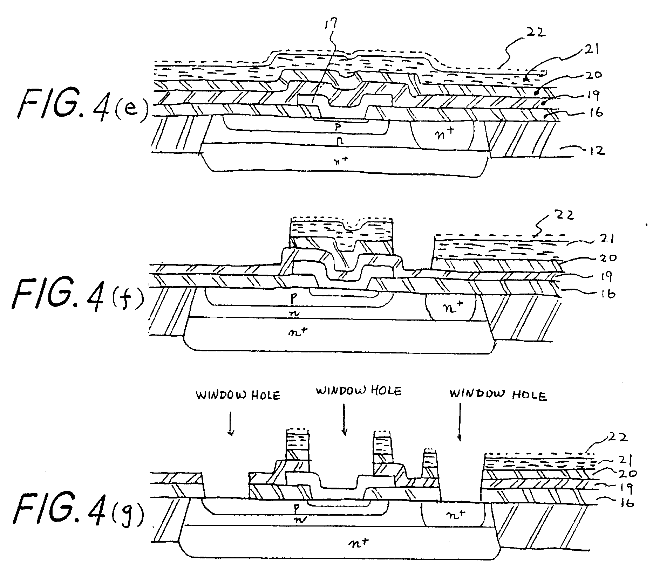

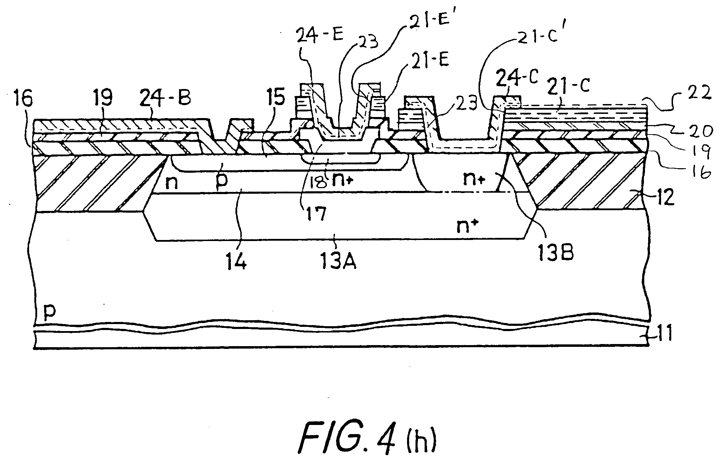

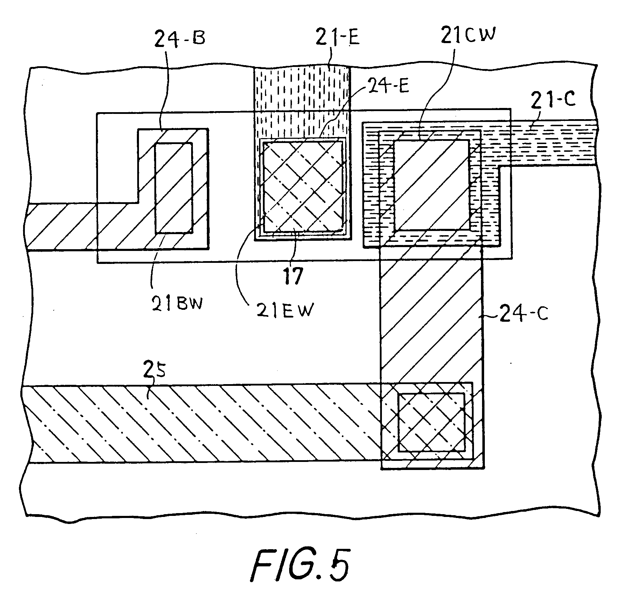

Referring to FIGs. 4 and 5, a preferred embodiment of the present invention is hereinafter described in detail. FIG. 4 schematically illustrates a cross-sectional side view of main portion of a bipolar semiconductor device, in which the collector wiring and emitter wirings are formed of a superconductive ceramic material while the base wiring is of normal metal, according to the present invention. FIG. 5 schematically illustrates a plan view of the semiconductor device of FIG. 4. In the figures, the numeral 11 denotes a p-type silicon substrate; the numeral 12 denotes a field isolation layer; the numeral 13A denotes a n⁺-type buried layer; the numeral 13B denotes an n⁺-type collector contact region; the numeral 14 denotes a collector layer of an n-type silicon; the numeral 15 denotes a base layer of a p-type silicon; the numeral 16 denotes a first inter-layer insulation film formed of SiO₂; the numeral 17 denotes a polycrystalline silicon film containing an impurity; the numeral 18 denotes an n⁺-type emitter region; the numeral 19 denotes a second inter-layer insulating film formed of SiO₂; the numeral 20 denotes a third insulating film formed of MgO (magnesium oxide), SrTiO₃ (strontium titanate) or Al₂O₃ (aluminum oxide) in order to accomplish a good affinity between the lattices of the superconductive material and the SiO₂ film 19, because the good affinity of the lattices is essential to maintain the superconductivity; the numeral 21-C and 21-E denote a patterned layer wiring formed of a superconductive material for collector wiring and emitter wiring respectively; the numeral 21CW (FIG. 5) denotes an electrode-contact window hole provided through the superconductive wiring layer 21-C; the numeral 21EW (FIG. 5) denotes an electrode-contact window hole provided through the superconductive wiring layer 21-E; the numeral 22 denotes a passivation film formed of a TEFLON-like polymer material; the numeral 23 denotes a barrier metal layer formed of, for example, TiN (titanium nitride) or titanium (Ti) which is electrically conductive, for preventing aluminum atoms from forming an alloy with the silicon atoms in the semiconductor region 13B and 18 as well as in SiO₂ film 19 and 20; the numeral 24-B denotes a base electrode/wiring layer formed of a normal metal, such as aluminum, gold or tungsten (W), etc.; the numeral 24-E denotes an emitter electrode formed of a normal metal, such as aluminum, gold or tungsten, etc.; the numeral 24-C denotes a collector electrode formed of a normal metal, such as aluminum, gold or tungsten, etc.; and the numeral 25 denotes a resistor formed of polycrystalline silicon.

Fabrication processes of the semiconductor device shown in FIG. 4 and FIG. 5 are as follows. Each of the processes is of widely known technique.
(1) Forming the n⁺-type buried layer 13A in the silicon substrate 11 and n-type collector epitaxial layer 14 with the general bipolar semiconductor fabrication technique. Isolation region 12 may be formed with a general bipolar process technique. Fig. 4(a).
(2) Forming p-type silicon base layer 15 thereon. The formation of the p-type silicon base layer 15 may be carried out by a photolithographic step and ion implanting (Fig. 4(b)) an impurity, such as boron. The collector region 13B may be formed by a similar step carried out for the base region. Fig. 4(c).
(3) Forming the first SiO₂ inter-layer insulation film 16. Successively, exposing the base layer 15 by forming an emitter electrode window hole 21EW through the inter-layer insulation film 16 by a general etching technique.
(4) Forming the polycrystalline silicon film 17 containing proper impurity, such as arsenic. This formation is carried out by firstly forming impurity containing polycrystalline silicon film upon all over the surface of the substrate; and secondly removing all the portion except the portion in and in the vicinity of the above-described emitter electrode window hole 21EW by a general patterning technique, for example, photo lithography.
(5) Forming the emitter region 18 by diffusing the n⁺-type impurity arsenic from the impurity containing polycrystalline silicon film 17 into the base layer 15. Fig. 4(d).
(6) Depositing the second SiO2 inter-layer insulation film 19 upon the entire surface of the semiconductor substrate, in order to insulate the impurity containing polycrystalline silicon film 17 from other portions.
(7) Depositing the third insulation film 20 formed of magnesium oxide (MgO), strontium titanate (SrTiO₃) or aluminum oxide (Al₂O₃) entirely upon the second insulation film 19.
(8) Depositing a superconductive film 21 as thick as, for example 600 nm, by means of, for example, magnetron sputtering method in which the target is made of sintered mixture of barium, yttrium, copper oxide (Ba₂YCu_{4.5}O_{8.5-y}) as reported by Enomoto et al. on Japanese Journal of Applied Physics, 26, L1248, 1987.
(9) Heating the entire substrate in an oxygen containing atmosphere, for example, at approximately 920°C for approximately 2 hours so that the deposited/patterned layers 21-E and 21-C become superconductive.
(10) Depositing a TEFLON-like polymer layer 22 upon the entire fabricated surface of the semiconductor substrate by, for example, RF (radio frequency) plasma deposition by means of CHF₃ (trifluoro methane) gas treatment. The deposited TEFLON-like polymer material is effective to passivate particularly the superconductive layer wirings 21-E and 21-C. Fig. 4(e).
(11) Patterning the deposited superconductive film 21 and the third insulation film 20 to form the wiring layer 21-E for the emitter electrode 24-E and the layer wiring 21-C for the collector electrode 24-C. The etching of the superconductive material is carried out by a lithography technique using 0.5 nitric acid (HNO₃) solution as reported ibid, or by a reactive ion etching method using carbon tetrachloride (CCl₄) gas plasma. Fig. 4(f).
(12) Etching a part of the passivation film 22 and the superconductive layer wirings 21 respectively positioned above the collector electrode to form window hole 21CW and above the emitter electrode to form window hole 21EW, and a part of the third insulation film 20 positioned above the base region 15. The third insulation MgO film 20 may remain upon the second insulation film 19.
(13) Etching a part of the second and first SiO₂ insulation SiO₂ films 19 and 16 so as to form respectively the base electrode window hole 21 BW and above the collector electrode window hole 21CW exposing the collector contact region 13B and the base region 15 respectively, and to form the emitter electrode window hole 21EW exposing the polycrystalline silicon film 17 as well. Fig. 4(g).
(14) Depositing and patterning the TiN film 23 and the electrode 24-E and 24-C, and electrode/wiring 24-B each formed of normal metal, for example aluminum, filling all the window holes 21BW, 21EW and 21CW as well as extending upon the surface of the TEFLON-like film 22. The aluminum on the TiN may be alternatively replaced by gold and tungsten on titanium.
(15) Further deposition of generally used passivation film or insulation film for multiple layer wiring structure may be additionally stacked thereon depending on the requirements.

In the semiconductor device fabricated as described above, the wirings formed of the superconductive ceramic material do not touch the semiconductor region, i. e. the polycrystalline silicon film 17 or the collector contact region 13B. Therefore, the copper atoms in the superconductive material never diffuse into the semiconductor region to form an alloy with silicon atoms therein; accordingly there arises no problem that deteriorates the performance and the reliability of the device.

Moreover, the emitter electrode 24-B and the collector electrode 24-C including the TiN film 22 contact the superconductive layer's side wall 21-E' and 21-C' respectively, through which the wiring layers can be superconductive even when the wiring layer is anisotropically superconductive mainly in the horizontal direction. Therefore, there is essentially no contact resistance between the superconductive layers wiring and the emitter/collector electrodes.

Operation of bipolar semiconductor devices generally degrades at low temperature; however, the improvements of the operation at as low as 77 K are recently achieved as reported by J. C. S. Woo et al. titling "Optimization of Bipolar Transistor for Low Temperature Operation" on IEDM Technical Digest, PP401-404, 1987 and by J. M. C. Stock et al. titling "High Performance Operation of Silicon Bipolar Transistors at Liquid Nitrogen Temperature" on IEDM Technical Digest pp405-408, 1987. High current supply capability of bipolar transistor is suitable for the use in combination with the superconductive wirings to achieve a high speed operation.

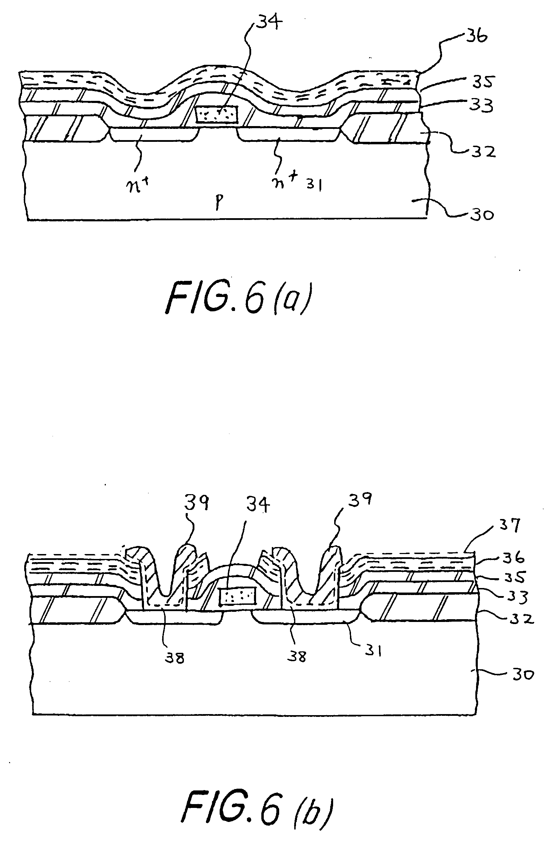

Another preferred embodiment of the invention concerning a MOS FET (metal oxide semiconductor, field effect transistor) is described hereinafter referring FIGs. 6(a) and 6(b).

According to the widely used methods for fabricating a MOS FET, the processes before the formation of window holes are carried out; i.e. n⁺ regions 31 in p-type substrate 30, field isolation 32 formed of SiO₂, an inter-layer insulation film 33 formed of 300 nm thick SiO₂, and polycrystalline silicon gate 34, are respectively fabricated. Next, MgO having a good lattice-affinity with the superconductive ceramic material is deposited as thin as 20 nm on the SiO₂ film 33 by a reactive sputtering of magnesium (Mg) in an oxygen atmosphere. Next, Ba₂YCu₃O_{7-y} (barium-yttrium-copper oxide, referred to hereinafter as BYCO) 36 is deposited entirely thereupon with magnetron sputtering method as reported by Enomoto, ibid.

Next, the entire semiconductor substrate is heated, for example, at approximately 920°C for approximately two hours. The BYCO layer 36 is etched to pattern a layer wiring. Next, a TEFLON-like polymer film 37 is deposited entirely thereupon as a passivation film with an RF plasma deposition method. Next, window holes are formed to expose the n⁺ region 31 through the passivation film 37, the BYCO film 36, the MgO film 35 and the inter-layer SiO₂ film 33. Next, the window holes are filled with a metal 38. This metal is preferably a so-called barrier metal, comprising, for example, TiN. A normal metal, such as aluminum is successively deposited to form the contact electrodes 39. Accordingly, the copper atoms in the superconductive material do not react with Si in the semiconduct or regions, while essentially zero contact resistance is achieved between the semiconductor region and the superconductive wiring.

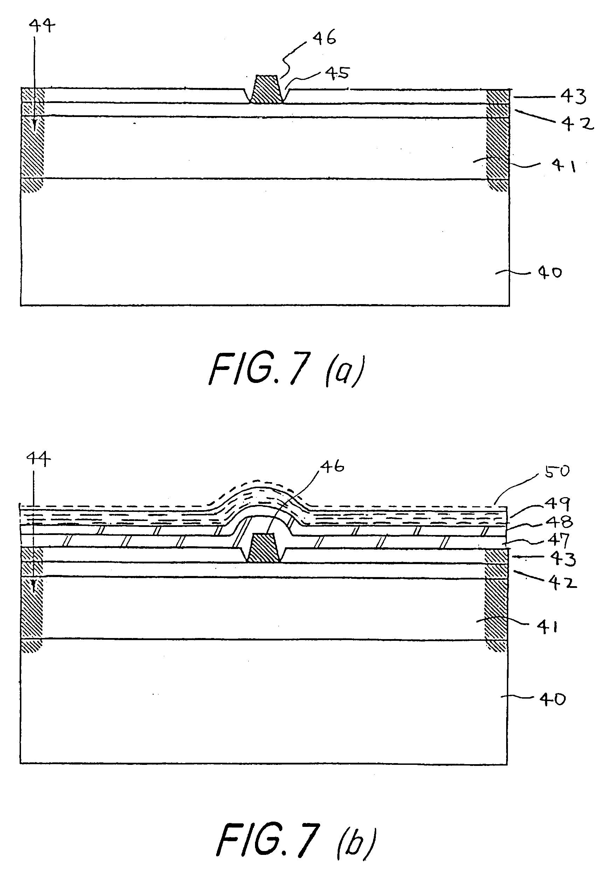

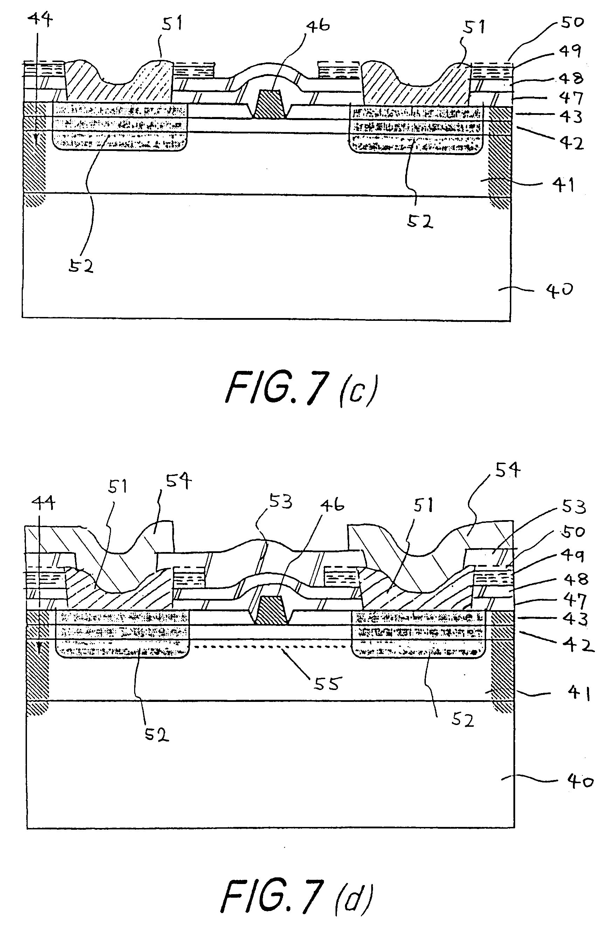

Still another preferred embodiment of a the invention concerning HEMT (high electron mobility transistor) is described hereinafter referring FIGS. 7(a) to 7(d). The processes before Au-Ge (gold-germanium) alloying process are carried out according to generally employed methods. In other words, with a widely employed MBE method, an undoped, i.e. intrinsic, GaAs (gallium arsenide) layer 41 on a GaAs substrate 40, an n-type doped AlGaAs layer 42 thereon, and an n-type GaAs layer 43 thereon respectively are continuously grown; oxygen atoms are selectively ion-implanted using a masking process into the field region so as to form an isolation region 44; only a portion 45, which will later become a gate, of the n-type GaAs layer 43 is selectively removed with a lithography technique; WSi₂ (tungsten silicide) is deposited entirely thereupon by a sputtering method; and only a portion 46 of the WSi₂ deposition, as a gate electrode, is left by a lift-off method; this state is shown in FIG. 7(a). Next, an inter-layer insulation film 47 formed of SiO₂ is deposited as thick as approximately 300 nm entirely over the n-type GaAs layer 43 as well as over the gate electrode 46 by a general CVD (chemical vapor deposition) method. Next, the MgO film 48 and the BYCO superconductive layer 49 are deposited thereon to form a multiple layer structure as shown in FIG. 7(b) by the same methods as described above for the MOS FET. Then, the entire substrate is heated in an atmosphere containing an oxygen gas at, for example, 500 to 800 °C for, for example, approximately one hour so that the BYCO layer 49 become superconductive. Next, the superconductive layer 49 and the MgO layer 48 are pattern-etched. Next, a TEFLON-like passivation film 50 is deposited upon the patterned surfaces by the same method as described above for the bipolar transistor. Next, a generally used photoresist film is coated all over the substrate, and the photoresist on portions for the window holes are removed with a wellknown photo etching process. Next, by the use of this photoresist, etching the passivation film 50, the patterned superconductive layer 49, the MgO layer 48, and the SiO₂ insulation film 47 as well, so as to form window holes exposing the portions for drain and source regions on the n-type GaAs layer 43. Next, Au-Ge (Au containing several percent of Ge) is deposited as thick as 3000 Å entirely upon the photoresist including the electrode portions exposed in the window holes by a general method. Next, the unnecessary portion of the Au-Ge deposited upon the photoresist is removed by removing the underlying photoresist, i.e. the widely used lift-off method, leaving each electrode 51. Next, the entire substrate is heated at approximately 410 °C for several minutes so that the deposited Au-Ge 51 forms an alloy with the GaAs 43 and the AlGaAs 42, thus the n⁺-type source and drain alloy regions 52 are formed. Next, a second inter-layer insulation film 53 formed of SiO₂ is deposited all over the surface of the substrate by a generally well known method. Next, the SiO₂ insulation film 53 is etched to form window holes for the electrodes by a generally well known method. Next, wirings 54 formed of Ti-Pt-Au layers are patterned upon the SiO₂ insulation film 53, as shown in FIG. 7(d), so as to connect the electrodes 51 with each other or to a terminal for outside connection. On operation of this HEMT, in the intrinsic GaAs layer 41 and in the vicinity of the bordering plane to the n-type AlGaAs layer 42 a thin two-dimensional electron gas layer 55 is generated as shown by the dotted line in FIG. 7(d); this two-dimensional electron gas layer 55 acts as a channel of an FET.

In the embodiment of a HEMT as shown in Figs. 7, the AlGaAs layer 42 may be replaced with an n-GaAs layer having an impurity concentration of approximately 1 x 10⁻¹⁷cm⁻¹ so as to fabricate a GaAS MESFET.

With these process steps, the HEMT device or a MESFET do not suffer from any damage from the high temperature heat treatment process. Because the most temperature-sensitive part of these devices are the Au-Ge alloyed source/drain regions and these regions are formed after the heat treatment to form the superconductive material by heating the material up to 500 to 800 °C. If the conventional wiring of normal metal is simply replaced by the superconductive material without introducing the present invention, the high temperature heat process to produce the superconductive property has to be carried out after the Au-Ge is deposited, accordingly causes the damage of the GaAs and the AlGaAs. Thus, this configuration, which uses the present invention, is beneficially advantageous particularly in the HEMT or GaAs MESFET structure.

Though in the above-described embodiments the electrode 24, 39 or 51, each formed of normal metal such as aluminum, tungsten, gold or gold-germanium alloy, contacts the inner side-wall 62 of a window hole, (Fig. 8(b)) in a superconductive layer directly or via the barrier metal such as TiN, as shown in FIG. 8(b), the contact point may be the end wall 60 or the longitudinal side wall 61 as shown in FIG. 8(a) or any other arbitrary shape of the side wall 63 like shown in FIG. 8(c) as long as the contact point is on the essentially orthogonal wall to the superconductive direction which is along the surface (1 1 0) in the figures, where the layer is anisotropically superconductive mainly along the direction of the surface (1 1 0) deposited upon the (1 1 0) surface of a substrate. In other words, the wall which the normal metal electrode is to contact to enjoy the superconductive property of the layer wiring when the wiring layer is anisotropically superconductive, is indicated by hatching in FIGs. 8. Though in FIGs. 8 the hatched sides are drawn as orthogonal to the (1 1 0) plane, this side may be slanted as long as this side is used for contacting the normal metal electrode.

Though in the preferred embodiment of FIG. 4 and 5 the superconductive material is used only for the emitter and collector wirings in which relatively big current is handled but the normal metal is used for the base wiring, it is apparent that the superconductive material may be employed to any one of the wirings on requirement.

Though mostly only one procedure is referred to for the fabrication steps in each of the preferred embodiments of the present invention, any other generally used method can be employed in the above-described processes such as deposition, etching, patterning and wiring.

## Claims

1. A semiconductor device characterized by a semiconductor substrate (1; 11; 30; 40) within which or on which a plurality of semiconductor regions (4, 5; 13A, B, 14, 15, 18; 31; 52) are fabricated;
a wiring layer (21; 36; 49) formed of an electrically superconductive material insulated from said semiconductor substrate (1; 11; 30; 40) and said semiconductor regions (4, 5; 13A, B, 14, 15, 18; 31; 52) by an insulation film (6; 16, 19, 20; 35; 48), said wiring layer (21; 36; 49) being anisotropically superconductive mainly in a direction parallel to a plane of deposition of said wiring layer (21; 36; 49);
and an electrode (23, 24; 39; 51) formed of a normal metal on one of said semiconductor regions (4, 5; 13A, B, 14, 15, 18; 31; 52), for electrically connecting said one semiconductor region (4, 5; 31; 52) to said electrically superconductive wiring layer (21; 36; 49), said electrode (23, 24; 39; 51) contacting said wiring layer (21; 36; 49) at least at said wiring layer's side-wall.

2. A semiconductor device according to claim 1,
characterized in that
said electrode (23; 39; 51) contacts said wiring layer (21; 36; 49) at an inner side-wall of a window hole (62, 63) provided in said wiring layer (21; 36; 49).

3. A semiconductor device according to claim 1 or 2,
characterized in that
said electrically superconductive material is a ceramic containing a copper oxide.

4. A semiconductor device according to anyone of claims 1 to 3,
characterized in that
the material of said normal metal electrode (4; 39; 51) is chosen from the group containing aluminium, gold, gold-germanium alloy, titanium and tungsten.

5. A semiconductor device according to claim 4,
characterized by
said substrate (11; 30) and said one semiconductor region (13B, 18; 31) being of silicon and said insulation film (16, 19, 20; 35) being of silicon dioxide, and by a barrier metal layer (23; 38) positioned between said electrode (24; 39) and said superconductive wiring layer (21, 36) and between said electrode (24; 39) and said one semiconductor region (13B, 18; 31) so as to prevent reaction of said normal metal with silicon in said one semiconductor region (13B, 18; 31) and with said insulation film (16, 19, 20; 35).

6. A semiconductor device according to claim 5,
characterized in that
said barrier metal is chosen from the group containing titanium, molybdenum, and titanium nitride.

7. A semiconductor device according to anyone of claims 1 to 6,
characterized in that
said insulation film (6; 35; 48) is formed of silicon dioxide comprising a magnesium oxide film thereon, said magnesium oxide film contacting said wiring layer (21; 36; 49).

8. A semiconductor device according to claim 1,
characterized in that
the substrate (40) is semi-insulating and comprises a III-V family semiconductor compound;
the semiconductor regions comprise an undoped III-V family binary semiconductor compound layer (41) positioned on said substrate (40),
a doped III-V family ternary semiconductor compound layer (42) positioned on said undoped layer (41), and
a doped III-V family binary semiconductor compound layer (43) positioned on said ternary layer (42);
and the electrode (51) contacts said side-wall of said superconductive wiring layer (49) and said doped III-V family binary semiconductor layer (43).

9. A semiconductor device according to claim 1,
characterized in that
the substrate is semi-insulating and comprises a III-V family semiconductor compound; the semiconductor regions comprise an n-type III-V family semiconductor compound layer positioned on said substrate,
a first doped III-V family binary semiconductor compound layer positioned on said undoped layer, and
a second doped III-V family binary semiconductor compound positioned on said first binary layer;
and the electrode contacts said side-wall of said superconductive wiring layer and said second doped III-V family binary semiconductor layer.

## Patentansprüche

1. Halbleitervorrichtung, gekennzeichnet durch ein Halbleitersubstrat (1; 11; 30; 40), innerhalb von welchem oder auf welchem eine Vielzahl von Halbleiterzonen (4, 5; 13A, B, 14, 15, 18; 31; 52) hergestellt sind;
eine Verdrahtungsschicht (21; 36; 49), welche aus einem elektrisch supraleitenden Material gebildet ist, das von dem genannten Halbleitersubstrat (1; 11; 30; 40) und den genannten Halbleiterzonen (4, 5; 13A, B, 14, 15, 18; 31; 52) durch eine dünne Isolierschicht (6; 16, 19, 20; 35; 48) isoliert ist, wobei die genannte Verdrahtungsschicht (21; 36; 49) vorwiegend in einer Richtung parallel zu einer Ablagerungsebene der genannten Verdrahtungsschicht (21; 36; 49) anisotropisch supraleitend ist;
und eine Elektrode (23, 24; 39; 51), welche aus einem normalen Metall auf einer der genannten Halbleiterzonen (4, 5; 13A, B, 14, 15, 18; 31; 52) zum elektrischen Verbinden der genannten einen Halbleiterzone (4, 5; 31; 52) mit der genannten elektrisch supraleitenden Verdrahtungsschicht (21; 36; 49) ausgebildet ist, wobei die genannte Elektrode (23, 24; 39; 51) die genannte Verdrahtungsschicht (21; 36; 49) mindestens an einer Seitenwand der genannten Verdrahtungsschicht kontaktiert.

2. Halbleitervorrichtung nach Anspruch 1, dadurch gekennzeichnet, daß die genannte Elektrode (23; 39; 51) die genannte Verdrahtungsschicht (21; 36; 49) an einer inneren Seitenwand einer Fensteröffnung (62, 63) kontaktiert, welche in der genannten Verdrahtungschicht (21; 36; 49) vorgesehen ist.

3. Halbleitervorrichtung nach Anspruch 1 oder 2, dadurch gekennzeichnet, daß das genannte elektrisch supraleitende Material ein keramischer Werkstoff ist, welcher Kupferoxid enthält.

4. Halbleitervorrichtung nach einem der Ansprüche 1 bis 3, dadurch gekennzeichnet, daß das Material der genannten normalen Metallelektrode (4; 39; 51) aus der Gruppe ausgewählt ist, welche Aluminium, Gold, Gold-Germaniumlegierung, Titan und Wolfram umfaßt.

5. Halbleitervorrichtung nach Anspruch 4, gekennzeichnet dadurch, daß das genannte Substrat (11; 30) und die genannte eine Halbleiterzone (13B, 18; 31) aus Silizium bestehen und die genannte Isolierschicht (16, 19, 20; 35) aus Siliziumdioxid besteht, und dadurch,
daß eine metallische Sperrschicht (23; 38) zwischen der genannten Elektrode (24; 39) und der genannten supraleitenden Verdrahtungsschicht (21. 36) und zwischen der genannten Elektrode (24; 39) und der genannten einen Halbleiterzone (13B, 18; 31) angeordnet ist, um eine Reaktion des genannten normalen Metalls mit dem Silizium in der genannten einen Halbleiterzone (13B, 18; 31) und mit der genannten dünnen Isolierschicht (16, 19, 20; 35) zu verhindern.

6. Halbleitervorrichtung nach Anspruch 5, dadurch gekennzeichnet, daß das genannten Sperrschichtmetall aus der Gruppe gewählt ist, welche Titan, Molybdän und Titaniumnitrid umfaßt.

7. Halbleitervorrichtung nach einem der Ansprüche 1 bis 6, dadurch gekennzeichnet, daß die Isolierschicht (6; 35; 48) aus Siliziumdioxid mit einer darauf befindlichen Magnesiumoxidschicht gebildet ist, wobei die genannte Magnesiumoxidschicht die genannte Verdrahtungsschicht (21; 36; 49) kontaktiert.

8. Halbleitervorrichtung nach Anspruch 1, dadurch gekennzeichnet,
daß das Substrat (40) halbisolierend ist und eine Halbleiterverbindung der III-V-Familie umfaßt;
daß die Halbleiterzonen eine undotierte Schicht (41) binärer Halbleiterverbindungen der III-V-Familie umfassen, die auf dem genannten Substrat (40) angeordnet ist,
wobei eine dotierte Schicht (42) ternärer Halbleiterverbindungen (42) der III-V-Familie auf der genannten undotierten Schicht (41) angeordnet ist, und
eine dotierte Schicht (43) binärer Halbleiterverbindung der III-V-Familie auf der genannten ternären Schicht (42) angeordnet ist;
und daß die Elektrode (51) die genannte Seitenwand der genannten supraleitenden Verdrahtungsschicht (49) und die genannte dotierte binäre Halbleiterschicht (43) der III-V-Familie kontaktiert.

9. Halbleitervorrichtung nach Anspruch 1, dadurch gekennzeichnet, daß
daß das Substrat halbisolierend ist und eine Halbleiterverbindung der III-V-Familie umfaßt;
daß die Halbleiterzonen eine undotierte n-Typ-Schicht von Halbleiterverbindungen der III-V-Familie umfassen, die auf dem genannten Substrat angeordnet ist,
wobei eine erste dotierte Schicht binärer Halbleiterverbindungen der III-V-Familie auf der genannten undotierten Schicht (41) angeordnet ist, und
eine zweite dotierte Schicht binärer Halbleiterverbindung der III-V-Familie auf der genannten ersten binären Schicht angeordnet ist;
und daß die Elektrode die genannte Seitenwand der genannten supraleitenden Verdrahtungsschicht und die genannte zweite dotierte binäre Halbleiterschicht der III-V-Familie kontaktiert.

## Revendications

1. Dispositif à semiconducteur caractérisé par un substrat semiconducteur (1 ; 11 ; 30 ; 40) à l'intérieur duquel ou sur lequel une pluralité de régions semiconductrices (4, 5 ; 13A, B, 14, 15, 18 ; 31 ; 52) sont fabriquées ;
une couche de câblage (21 ; 36 ; 49) réalisée en un matériau électriquement supraconducteur isolée dudit substrat semiconducteur (1 ; 11 ; 30 ; 40) et desdites régions semiconductrices (4, 5 ; 13A, B, 14, 15, 18 ; 31 ; 52) par un film d'isolation (6 ; 16, 19, 20 ; 35 ; 48), ladite couche de câblage (21 ; 36 ; 49) étant supraconductrice de façon anisotrope principalement suivant une direction parallèle à un plan de dépôt de ladite couche de câblage (21 ; 36 ; 49) ; et
une électrode (23, 24 ; 39 ; 51) formée en un métal normal sur l'une desdites régions semiconductrices (4, 5 ; 13A, B, 14, 15, 18 ; 31 ; 52) pour connecter électriquement ladite région semiconductrice considérée (4, 5 ; 31 ; 52) à ladite couche de câblage électriquement supraconductrice (21 ; 36 ; 49), ladite électrode (23, 24 ; 39 ; 51) entrant en contact avec ladite couche de câblage (21 ; 36 ; 49) au moins au niveau de la paroi latérale de ladite couche de câblage.

2. Dispositif à semiconducteur selon la revendication 1, caractérisé en ce que ladite électrode (23 ; 39 ; 51) entre en contact avec ladite couche de câblage (21 ; 36 ; 49) au niveau d'une paroi latérale interne d'un trou de fenêtre (62, 63) ménagé dans ladite couche de câblage (21 ; 36 ; 49).

3. Dispositif à semiconducteur selon la revendication 1 ou 2, caractérisé en ce que ledit matériau électriquement supraconducteur est une céramique contenant de l'oxyde de cuivre.

4. Dispositif à semiconducteur selon l'une quelconque des revendications 1 à 3, caractérisé en ce que le matériau de ladite électrode en métal normal (4 ; 39 ; 51) est choisi dans le groupe contenant l'aluminium, l'or, un alliage d'or-germanium, le titane et le tungstène.

5. Dispositif à semiconducteur selon la revendication 4, caractérisé en ce que :
ledit substrat (11 ; 30) et ladite région semiconductrice considérée (13B, 18 ; 31) sont en silicium et ledit film d'isolation (16, 19, 20 ; 35) est en dioxyde de silicium, et en ce qu'une couche métallique barrière (23 ; 38) est positionnée entre ladite électrode (24 ; 39) et ladite couche de câblage supraconductrice (21, 36) ainsi qu'entre ladite électrode (24 ; 39) et ladite région semiconductrice considérée (13B, 18 ; 31) de manière à empêcher une réaction dudit métal normal avec le silicium contenu dans ladite région semiconductrice considérée (13B, 18 ; 31) et avec ledit film d'isolation (16, 19, 20 ; 35).

6. Dispositif à semiconducteur selon la revendication 5, caractérisé en ce que ledit métal barrière est choisi dans le groupe qui contient le titane, le molybdène et le nitrure de titane.

7. Dispositif à semiconducteur selon l'une quelconque des revendications 1 à 6, caractérisé en ce que ledit film d'isolation (6 ; 35 ; 48) est formé en dioxyde de silicium comprenant un film d'oxyde de magnésium dessus, ledit film d'oxyde de magnésium entrant en contact avec ladite couche de câblage (21 ; 36 ; 49).

8. Dispositif à semiconducteur selon la revendication 1, caractérisé en ce que le substrat (40) est semi-isolant et comprend un composé semiconducteur de la famille III-V ;
les régions semiconductrices comprennent une couche de composé semiconducteur binaire de la famille III-V non dopée (41) placée sur ledit substrat (40) ;
une couche de composé semiconducteur ternaire de la famille III-V dopée (42) placée sur ladite couche non dopée (41) ; et
une couche de composé semiconducteur binaire de la famille III-V dopée (43) placée sur ladite couche ternaire (42) ; et
l'électrode (51) entre en contact avec ladite paroi latérale de ladite couche de câblage supraconductrice (49) et avec ladite couche semiconductrice binaire de la famille III-V dopée (43).

9. Dispositif à semiconducteur selon la revendication 1, caractérisé en ce que :
le substrat est semi-isolant et comprend un composé semiconducteur de la famille III-V ;
les régions semiconductrices comprennent une couche de composé semiconducteur de la famille III-V de type n placée sur ledit substrat ;
une première couche de composé semiconducteur binaire de la famille III-V dopée placée sur ladite couche non dopée ; et
un second composé semiconducteur binaire de la famille III-V dopé placé sur ladite première couche binaire ; et
l'électrode entre en contact avec ladite paroi latérale de ladite couche de câblage supraconductrice et avec ladite seconde couche semiconductrice binaire de la famille III-V dopée.
